Europäisches Patentamt

European Patent Office

Office européen des brevets

(19)

(11) **EP 1 150 467 A1**

(12) **EUROPEAN PATENT APPLICATION**

(43) Date of publication:
**31.10.2001 Bulletin 2001/44**

(51) Int Cl.[7]: **H04L 25/49**, H04L 25/14,
G06F 1/32, H03M 5/14

(21) Application number: **00830322.4**

(22) Date of filing: **28.04.2000**

| | |
|---|---|
| (84) Designated Contracting States:<br>**AT BE CH CY DE DK ES FI FR GB GR IE IT LI LU<br>MC NL PT SE**<br>Designated Extension States:<br>**AL LT LV MK RO SI**<br><br>(71) Applicant: **STMicroelectronics S.r.l.**<br>**20041 Agrate Brianza (Milano) (IT)**<br><br>(72) Inventors:<br>• **Fornaciari, William**<br>**43100 Parma (IT)** | • **Sciuto, Donatella**<br>**20123 Milano (IT)**<br>• **Silvano, Christina**<br>**20099 Sesto San Giovanni (Milano) (IT)**<br>• **Zafalon, Roberto**<br>**30125 Venezia (IT)**<br>• **Pau, Danilo**<br>**20099 Sesto San Giovanni (Milano) (IT)**<br><br>(74) Representative: **Bosotti, Luciano et al**<br>**Buzzi, Notaro & Antonielli d'Oulx**<br>**Corso Fiume 6**<br>**10133 Torino (IT)** |

(54) **Encoder architecture for parallel busses**

(57) An encoder/decoder architecture for buses, capable of minimizing power consumption by reducing the switching activity, generates, from an input information value ($b^{(t)}$) relating to a given instant ($t$), a corresponding current output value ($B^{(t)}$) on encoded bus lines relating to the same given instant. The architecture comprises storage means (10, 12) for storing respective preceding values of input information ($b^{(t-1)}$) and output information ($B^{(t-1)}$) relating to instants preceding the aforesaid given instant ($t$). A prediction block (P) generates, from the preceding value of input information, an estimate ($b^{\wedge(t)}$) of the current input information value. A decorrelation block (D) decorrelates the current input information value ($b^{(t)}$) with respect to the said estimate. Finally, a selection block (S) selects as the current output value ($B^{(t)}$) one out of the current input information value ($b^{(t)}$), the result of the decorrelation ($e^{(t)}$) implemented by the decorrelation block (D) or the preceding output value ($B^{(t-1)}$).

Fig.3

**Description**

<u>Technical field</u>

The present invention relates to encoder/decoder devices and particularly to their architecture.

<u>Prior art</u>

The problem of reducing switching activity in high capacitance bus lines has been studied widely in the prior art.

In particular, there are techniques based on the solution of encoding the data sources before transmission on the bus according to the specific spectral characteristics of the streams and the patterns to be exchanged.

For example, in the paper by M.R. Stan and W.P. Burleson, "Bus-Invert Coding for Low-Power I/O", IEEE Transactions on Very Large Scale Integration Systems, Vol. 3, No. 1, PP 49-58, March 1995, the authors propose a redundant encoding scheme, called the Bus-Invert code, suitable for transmitting patterns randomly distributed in time, for data buses for example. The major drawbacks of this approach are related to the redundancy required in the bus lines and the overheads in terms of power and delay introduced by the elements known as "majority voters" included in the encoder.

Where address buses are concerned, other techniques, based on what is known as the spatial locality principle, have been explored. In this respect, it will be helpful to refer to the book by J.L. Hennessy and D.A. Patterson, Computer Architecture - A Quantitative Approach, 2nd edition, Morgan Kaufmann Publishers, 1996. In the case of address buses, sequential addressing is usually predominant, and therefore the temporal correlation between successive addresses is generally very large. The paper by C.L. Su, C.Y. Tsui and A.M. Despain, "Saving power in the Control Path of Embedded Processors", IEEE Design and Test of Computers, Vol. 11, No. 4, pp. 24-30, Winter 1994, proposed the encoding of the patterns with a Gray code such that a transition of one bit only is ensured between consecutive addresses. However, this paper did not take into account the power overhead caused by the presence of the Gray encoder/decoder. The paper by H. Mehta, R.M. Owens and M.J. Irwin, "Some Issues in Gray Code Addressing", GLS-VLSI-96: IEEE 6th Great Lakes Symposium on VLSI, pp. 178-180, Ames, IA, March 1996, provided a further analysis of addressing based on the Gray codes and the corresponding architecture, with particular regard to the aspect of the modification of the Gray code in order to preserve the one-transition property in the consecutive addresses in the case of byte-addressable machines.

The papers by L. Benini, G. De Micheli, E. Macii, D. Sciuto and C. Silvano, "Asymptotic Zero-Transition Activity Encoding for Address Buses in Low-Power Microprocessor-Based Systems", GLS-VLSI-97: IEEE 7th Great Lakes Symposium on VLSI, pp. 77-82, Urbana, IL, March 1997, and L. Benini, G. De Micheli, E. Macii, D. Sciuto and C. Silvano, "Address Bus Encoding Techniques for System-Level Power Optimization", DATE-98, pp. 861-866, Feb. 1998, proposed a redundant encoding scheme, called the T0 code, which avoids the transfer of consecutive addresses on the bus. This result is achieved by using a redundant line, INC, to transfer to the sub-system acting as the receiver the information relating to the sequential organization of the addresses. The increments between consecutive patterns can be parametric, thus reflecting the addressability scheme adopted in the memory architecture. In stable operating conditions of infinite streams of consecutive addresses, the code T0 has the property imparted by the number of transitions on the bus, equal to 0. On the other hand, addressing based on the Gray code requires a switching or transition of one bit for each pair of consecutive configurations.

An extension of the capabilities of the T0 code proposed in the last two papers cited is provided by the T0-Xor code, produced by combining the T0 code with an Xor function. The presence of this function, which has the effect of decorrelation, makes it unnecessary to introduce into the bus the redundant line INC which is required for the T0. It should be noted that the T0-Xor code can also be derived from the architecture proposed in the paper by S. Ramprasad, N.R. Shanbhag and I.N. Hajj, "A Coding Framework for Low-Power Address and Data Buses", IEEE Trans. On Very Large Scale Integration (VLSI) Systems, Vol. 7, No. 2, June 1999, pp. 212-221, where it is called the Inc-Xor code.

In the case of what is known as the Offset code, the difference between the current value of $b^{(t)}$ and the preceding value $b^{(t-1)}$ is transmitted on the bus. When the values transmitted on the buses have a high correlation, the value on the bus lines encoded $B^{(t)}$ is reduced and is kept constant for in-sequence data. The difference uses sign and quantity (magnitude) encoding with the sign bit represented as a redundant bit.

In the Offset-Xor code, the difference $(b^{(t)} - b^{(t-1)})$ is first calculated, and then an xor function is executed between the values of the bus lines encoded at the times t and t-1. The xor function has a decorrelating effect on the output. In fact, it simply translates the bits of $B^{(t)}$ with a value of 1 into transitions on the bus lines, while the bits with the value of 0 correspond to stationary bus lines.

In the T0-Offset code, the capabilities of the T0 code are extended by adopting the T0 scheme for in-sequence bus values, while for the out-of-sequence bus values the Offset code is used. The basic idea still exploits the spatial locality principle: this is because it is assumed that, for the out-of-sequence bus values, the fact of encoding the differences ($b^{(t)}$ - $b^{(t-1)}$) could imply fewer transitions on the bus lines than binary encoding of the value $b^{(t)}$.

Other codes can be derived by extending the capabilities of the described codes or simply by combining the preceding codes, as illustrated in the paper by L. Benini, G. De Micheli, E. Macii, D. Sciuto and C. Silvano cited above, where the Dual-T0, T0-BI and Dual-T0-BI codes are derived.

The T0-Xor-Offset code can be derived by combining the T0-Xor scheme for in-sequence bus values, while using the Offset code for the out-of-sequence bus values.

In the T0 code with a variable value of what is known as the "stride", namely the T0-Var code, the stride between consecutive patterns can be made parametric. Redundant bus lines are introduced to enable different stride values (such as 4, 8 and 16) to be handled, so that the most frequently occurring distances between consecutive addresses can be represented. For n values of stride $S_1$, $S_2$, ..., $S_n$, we need $\log_2 (S_n)$ redundant lines, in other words $INC_1$, $INC_2$, ..., $INC_n$.

The reduced Bus Invert code, also called the Red-BI code, makes use of the fact that the most significant bits of the system bus have a lower transition activity than the least significant bits. Thus, the threshold beyond which the bus value is inverted is reduced to a number less than N/2. For example, the procedure can be implemented by using a reduced number of 23 or 24 bus lines, instead of 32 bus lines.

The paper by E. Musoll, T. Lang and J. Cortadella, "Working-Zone Encoding for Reducing the Energy in Microprocessor Address Buses", IEEE Transactions on Very Large Scale Integration (VLSI) Systems, Vol. 6, No. 4, pp. 568-572, Dec. 1998, originates from the consideration of the fact that a given program tends to favour a limited number of working zones of the address memory space at each instant of time. Consequently, given the reference to the current working zone, the bus transmits only the information related to the offset of this reference with respect to the preceding reference to this zone.

The Working Zone Encoding (WZE) scheme is suitable when the address sequentiality is destroyed either by interleaved accesses to different data arrays or by interleaved accesses to instruction and data locations. The main limitation of this technique is due to its fixed encoder/decoder logic overhead, which is higher, so that it limits the advantages in terms of power related to the reduction of the switching activity. Moreover, this solution introduces additional delays into the critical signal paths. A further drawback is due to the fact that redundant bus lines are required to communicate the change of the working zone. Furthermore, this technique is based on rather limiting assumptions concerning the patterns in the stream. If the data-access policy is not array-based, or if the number of the working zones is too great, this encoding scheme loses its effectiveness.

Other encoding techniques at the system level have been examined in the papers by M.R. Stan and W.P. Burleson, "Low-Power Encodings for Global Communication in CMOS VLSI", IEEE Transactions on Very Large Scale Integration (VLSI) Systems, Vol. 5, No. 4, pp. 444-455, Dec. 1997, and M.R. Stan and W.P. Burleson, "Limited-Weight Codes for Low-Power", IWLPD-94: IEEE/ACM International Workshop on Low Power Design, pp. 209-214, Napa Valley, CA, April 1994, while a general encoding/decoding framework aimed at reducing the transition activity has recently been proposed in the paper by S. Ramprasad, N.R. Shanbhag and I.N. Hajj, "A Coding Framework for Low-Power Address and Data Buses", IEEE Trans. On Very Large Scale Integration (VLSI) Systems, Vol. 7, No. 2, June 1999, pp. 212-221, cited above. Although most of the low-power encoding techniques can be implemented by using this framework, the critical path for transmitting information on the bus can have a significant effect on the performance at system level. Theoretical considerations concerning bus encoding techniques with a reduced number of transitions have been analysed in the paper by S. Ramprasad, N.R. Shanbhag and I.N. Hajj, "Information-Theoretic Bounds on Average Signal Transition Activity", IEEE Trans. On Very Large Scale Integration (VLSI) Systems, Vol. 7, No. 3, Sep. 1999, pp. 359-368, where the authors derive lower and upper limits of the average signal transition activity.

All the aforementioned schemes are suitable for general-purpose microprocessor-based systems, while the paper by L. Benini, G. De Micheli, E. Macii, M. Poncino and S. Quer, "Power Optimization of Core-Based Systems by Address Bus Encoding", IEEE Transactions on Very Large Scale Integration (VLSI) Systems, Vol. 6, No. 4, pp. 554-562, Dec. 1998, analyses application-dependent encoding methods for systems of the embedded type designed for specific functions. The paper by L. Benini, A. Macii, E. Macii, M. Poncino and R. Scarsi, "Synthesis of Low-Overhead Interfaces for Power-Efficient Communication over Wide Buses", DAC-99, New Orleans, Louisiana, June 1999, proposes algorithms for the synthesis of ad hoc encoding/decoding logics with a reduced number of transitions. This approach automatically derives codes with a low transition activity and the corresponding implementations at encoding/decoding level from a detailed statistical characterization of the target stream. The main limitation of application-dependent solutions relates to their applicability which is limited to dedicated systems designed to execute the same given program many times.

The paper by S. Ramprasad, N.R. Shanbhag and I.N. Hajj, "A Coding Framework for Low-Power Address and Data Buses", IEEE Trans. On Very Large Scale Integration (VLSI) Systems, Vol. 7, No. 2, June 1999, pp. 212-221, cited above, proposes a general architecture of an encoding scheme for low-power buses. In this architecture, the information source $b^{(t)}$ is first processed by a function $f_1$ which decorrelates $b^{(t)}$ with respect to its prediction $b^{\wedge(t)}$, and then a variant of the entropic encoding function $f_2$ is introduced so that the average number of transitions is reduced. The information is made to pass through an xor function, which decorrelates the information with respect to the data which appeared on the bus in the preceding clock cycle. The same paper derives the performances of various codes in terms of transition activity and reports some considerations relating to the area occupation, delays and power absorption of the encoder/ decoder with respect to the Gray, T0 and INC-Xor schemes. This generic architecture can be specialized by using different alternatives for the internal decorrelating functions, thus enabling most of the low-power encoding techniques of known types to be derived. However, the critical path for transmitting the information on the bus can have a significant effect on the system-level performance. This is because the critical path delay of the encoder is formed by means of the $f_1$, $f_2$ and xor functions, where $f_1$ can implement an xor or dbm logic block, while $f_2$ can implement the identity, inv, vbm or pbm functions. In the best case, the critical path is provided by a pair of xor gates.

The bus encoding techniques described above have the aim of reducing the switching activity of the processor-to-memory interface by changing the format of the information transmitted on the bus. Other solutions are based on directly changing the way in which the information is stored in memory, so that the address streams already have a reduced transition activity: in this connection, reference may be made to the paper by P.R. Panda and N.D. Dutt, "Low-Power Memory Mapping Through Reducing Address Bus Activity", IEEE Transactions on Very Large Scale Integration (VLSI) Systems, Vol. 7, No. 3, pp. 309-320, Sep. 1999. Memory mapping techniques and bus encoding techniques are not mutually exclusive. The optimal strategies for power minimization must generally exploit their synergic action.

Objects and summary of the present invention

The object of the present invention is to overcome the problems surveyed above by means of an alternative solution.
According to the present invention, this object is achieved by means of an encoder/decoder architecture having the characteristics claimed specifically in the following claims. The invention also concerns the related bus-type processing system.
Essentially, the solution according to the invention is based on the recognition of the fact that, in microprocessor-based systems, it is possible to obtain considerable power savings by reducing the transition activity of the system buses. The power consumption due to the transition activity of the input/output pads in a VLSI circuit varies from 10% to 80% of the overall power, with a typical value of 50% for circuits optimized for low consumption. This fact has already been recognized in the first of the papers by S. Ramprasad, N.R. Shanbhag and I.N. Hajj cited above. The high power dissipation associated with the input/output pads is due to the high values of the off-chip capacitances, which are typically greater by two or three orders of magnitude than the on-chip capacitances. Minimizing the switching activity of the off-chip buses can yield significant savings in terms of power dissipation.
The present invention is focused on high-performance microprocessor-based systems in which very wide data and address buses are used for processor-to-memory communication. For this class of system, the invention aims to define dedicated bus interfaces and encoding architectures which reduce the transition activity on the buses at system level, which are
characterized by high values of capacitance. From this viewpoint, the invention can be seen as an ideal development of solutions which make use of the local nature of the data to reduce the switching power and which at the same time require a lower overhead in terms of delay in the critical path.
More specifically, the present invention proposes a general architecture for implementing different classes of bus encoding techniques which are efficient from the point of view of power consumption and whose main characteristic is that they reduce both the switching power and the bus latency. The low-power encoding/decoding architectures according to the invention can be used in combination with memory allocation techniques of the type described in the paper by P.R. Panda and N.D. Dutt, "Low-Power Memory Mapping Through Reducing Address Bus Activity", IEEE Transactions on Very Large Scale Integration (VLSI) Systems, Vol. 7, No. 3, pp. 309-320, Sep. 1999. These memory allocation techniques place the emphasis on the sequential nature of the accesses to minimize further the average number of transitions on the bus lines.
The main characteristics of the solution according to the invention are as follows.
The target system architecture considered here is very general and is capable of modelling the communication at hardware/software level on system-level buses in terms of the main parameters which affect the switching power of the system: power supply, frequency, transition activity and capacitive load.
The proposed encoding/decoding architecture implements different classes of bus encoding techniques and provides an optimization in terms of timing: the delay in the critical path is minimized to reduce the latency of the bus accesses.
To further improve the transition activity on the system-level buses, various low-power encoding techniques suitable for use on address buses characterized by a high locality of the memory references can be implemented by using the proposed encoder/decoder architecture.
The implementation of the encoding/decoding architecture demonstrates that, for buses with high capacitive loads, the saving in terms of power due to the reduction of the transition activity is not offset by the overhead in terms of power introduced by the encoding/decoding logic.

Detailed description of the drawings

The invention will now be described, purely by way of example and without restrictive intent, with reference to the attached drawings, in which:

- Figure 1 shows in a general way the architecture of the target system which can be implemented by means of the invention,
- Figure 2, comprising four different sections indicated respectively as a, b, c, and d, shows four possible bus interface configurations,
- Figure 3 shows, in the form of a block diagram, a possible configuration of an encoder structure operating according to the invention,
- Figures 4 to 7 show four different possible encoder/decoder architectures according to the invention, specialized according to the use of different encoding schemes,
- Figure 8 shows a possible modification of the encoder part of the architecture of Figure 4 developed for high-speed applications, and
- Figure 9 shows the high-speed version of the encoder section of the structure shown in Figure 5.

Detailed description of preferred embodiments of the invention

By way of introduction, it will be useful to describe in the first place the structure of the proposed architecture for modelling communication at system level. This will be done with a view to subsequently examining the proposed encoding schemes.

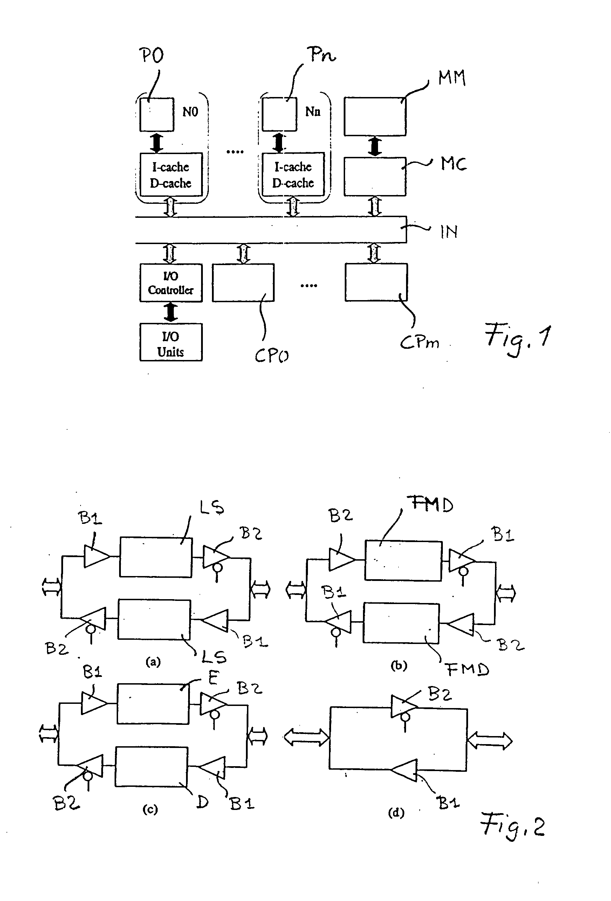

In particular, Figure 1 shows, in the form of a block diagram, the target system architecture. This is essentially a shared memory multi-processor system which can be implemented by using a structure of the monolithic type (System-On-a-Chip) or an approach of the multichip type.

The system comprises one or more processors P0, ..., Pn, the corresponding instruction caches (I-caches) and data caches (D-caches), the memory controller MC, the main memory MM, the input and output controllers (I/O controllers), the peripheral units, and the coprocessors CP0, ..., CPm to support specific applications (for example MPEG). All these basic blocks are connected through an interconnection network IN comprising address, data and control buses implemented by using different topologies. Given the target architecture, the main functional aspects are those relating to the hardware/software communication criteria both on the buses at sub-system level, such as the processor-to-cache buses, and on the buses at system level.

In the target architecture, a bus interface is introduced at the sub-system and system levels to make it possible to adapt the four parameters which affect the switching power of the system: power supply, frequency, switching activity, and capacitive load.

Figure 2 shows four different architectures for the bus interface module.

In particular, the solution shown in Figure 2a implements a scaling function by means of level shifting, implemented by modules LS which are essentially configured as level shifters. This type of interface is based on the approach known as multiple-level power supply voltage scheduling. In practice, the various parts of the target system architecture are supplied with different voltage levels in order to reduce the overall energy. Essentially, this solution proposes the reduction of power consumption while allowing for the limits in terms of throughput and resources. Essentially, the system modules which are located on the critical paths are supplied with the maximum voltage, thus preventing any increase in delay. On the other hand, the voltage supplied to the modules which are not on critical paths is minimized by voltage scaling techniques. The presence in the system of logic blocks supplied with different voltage levels makes it necessary to use level shifters, LS, at the bus interface.

In the solution shown in Figure 2b, on the other hand, frequency multiplier/demultiplier blocks FDM are used to carry out the modelling of the communication on the buses when the logic modules operate at different operating frequencies.

In the solution shown in Figure 2c, encoding blocks E and decoding blocks D are used in order to modify the transition activity of the buses. The structure of blocks E and D is discussed in greater detail below.

Finally, in the solution shown in Figure 2d, a buffer action is simply executed by means of corresponding modules B1, B2 (also provided in the other solutions described above) in order to decouple the capacitive loads. The buffers B1, B2 can be inserted at the module-to-bus interfaces and can be used to divide the whole bus into different bus segments. This solution is described, for example, in the paper by J.Y. Chen, W.B. Jone, J. Wang, H.-I. Lu and T. F. Chen, "Segmented Bus Design for Low-Power Systems," IEEE Transactions on Very Large Scale Integration (VLSI) Systems, Vol. 7, No. 1, pp. 25-29, Mar. 1999.

With specific reference to the encoding/decoding (Encdec) blocks mentioned above, the invention proposes a scheme which maintains a wide margin of generality while minimizing the critical path delays, to reduce the bus latency. The performance of the encoding/decoding scheme is an essential requirement, since the bus width and clock frequency increase constantly. It is therefore important to aim at a simultaneous optimization of the power and timing parameters.

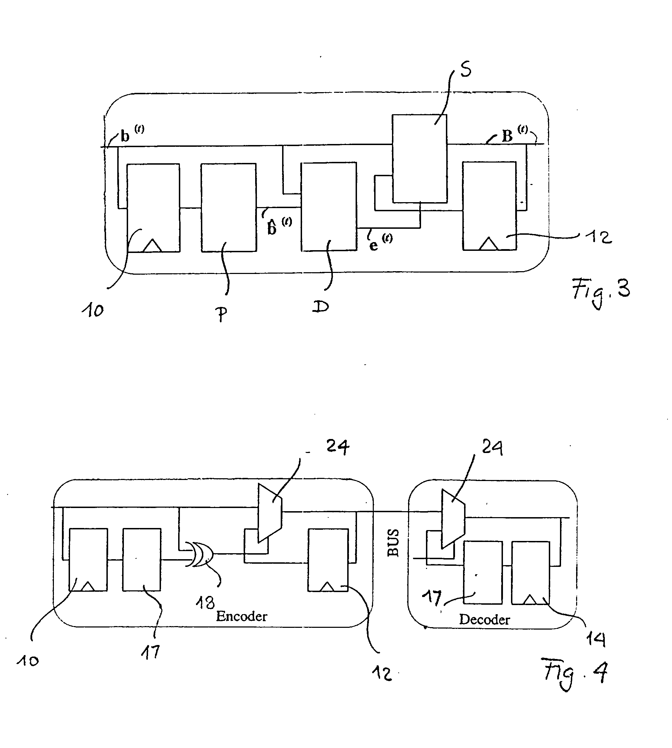

The corresponding encoding section is shown in general terms in Figure 3. The subsequent figures show the specific structures of the encoding and decoding sections for each of different encoding techniques considered.

In general, with reference to Figure 3, the encoder receives as the input $b^{(t)}$ the current value of information at the instant t and generates as its output $B^{(t)}$, the value on the bus lines encoded at the same instant t. The encoder in question comprises, in the first place, two registers 10, 12, for $b^{(t-1)}$ and $B^{(t-1)}$ respectively, in other words for the input and output values at the preceding instant t-1, together with three combinatorial logic blocks. More precisely, these consist of:

- a prediction block P which generates a prediction or estimate $b^{\wedge(t)}$ of the current value of $b^{(t)}$, based on the preceding value $b^{(t-1)}$, i.e.

$$b^{\wedge(t)} = P(b^{(t-1)}) \qquad (1)$$

- a decorrelation block D, which carries out an operation of decorrelating the output $b^{(t)}$ with respect to the aforesaid prediction or estimate value, i.e.

$$e^{(t)} = D(b^{(t)}, b^{\wedge(t)}) \qquad (2)$$

   and finally
- a selector block S which can select, as the output value, one of its inputs $b^{(t)}$, $B^{(t-1)}$ and $e^{(t)}$.

Since the object of the proposed encoding techniques is to minimize both the overall power consumption and the bus latency, the corresponding encoding functions are optimized with a twofold purpose.

On the one hand, it is necessary to ensure that the power overhead due to the encoder/decoder is kept below the power saving due to the reduction of the bus switching activity. Consequently, the hardware relating to the encoding functions must be contained as far as possible. On the other hand, critical path delay (through the D and S blocks) is minimized to reduce the latency of the bus access.

Preferably, an implementation of the pass-gate type is preferred, at least for some of the aforesaid logic blocks.

For example, we can consider the block S, which can implement the multiplexer (mux) or the xor function; in the first case, two pass-gates and an inverter are required, while in the second case two pass-gates and two inverters are required. In both cases, the critical path of the block S is given by the propagation delay through one inverter and one pass-gate.

The following table shows different possible implementations of the encoding functions P, D and S, corresponding to different classes of encoding (the column furthest to the left in the table) discussed in the introductory part of the preceding description.

| ENCODING | P | D | S | RED. |
|---|---|---|---|---|
| T0 | Inc. | Xor | Mux | Y |
| Bus-Invert | Id. | Xor | Inv. | Y |
| T0-Bus-Invert | Inc./Id. | Xor | Mux./Inv. | Y |
| T0-Xor | Inc. | Xor | Xor | N |
| Offset | Id. | Diff. | - | Y |
| Offset-Xor | Id. | Diff. | Xor | Y |
| T0-Offset | Inc./Id. | Xor/Diff. | Mux | Y |
| T0-Xor-Offset | Inc./Id. | Xor/Diff. | Xor | Y |

For each class of codes shown in the left-hand column, this table indicates the functions which are implemented for each of the blocks P, D and S, while the column furthest to the right shows that the scheme of the redundant type is (Y) or is not (N) processed. In the table, the symbol Inc. clearly identifies the redundant (incremental) line to which reference has been made a number of times in the introductory part of the description. The symbol Id. represents the identity function, the symbol Xor represents the homologous logic function and the symbol Diff. represents the difference. Finally the symbols Inv. and Mux. represent the logical inversion and multiplexer functions. It will be appreciated that registers relating to $B^{(t)}$ are not present in the case of the Offset code. In general, the structure shown in Figure 3 is mapped in Figures 4, 5, 6 and 7 in such a way that the T0, T0-Xor, Offset and Offset-xor codes respectively are implemented.

In Figures 4 to 7, the same alphanumeric references have been used to indicate parts which are identical or equivalent to those introduced in Figure 3. In these Figures 4 to 7, the numeric references 14 and 16 represent corresponding registers present in the decoding part.

In the same drawings, the numeric reference 17 indicates the Inc. function, while the reference 18 indicates corresponding logic gates of the Xor type. The references 20, 22 indicate difference and addition nodes respectively.

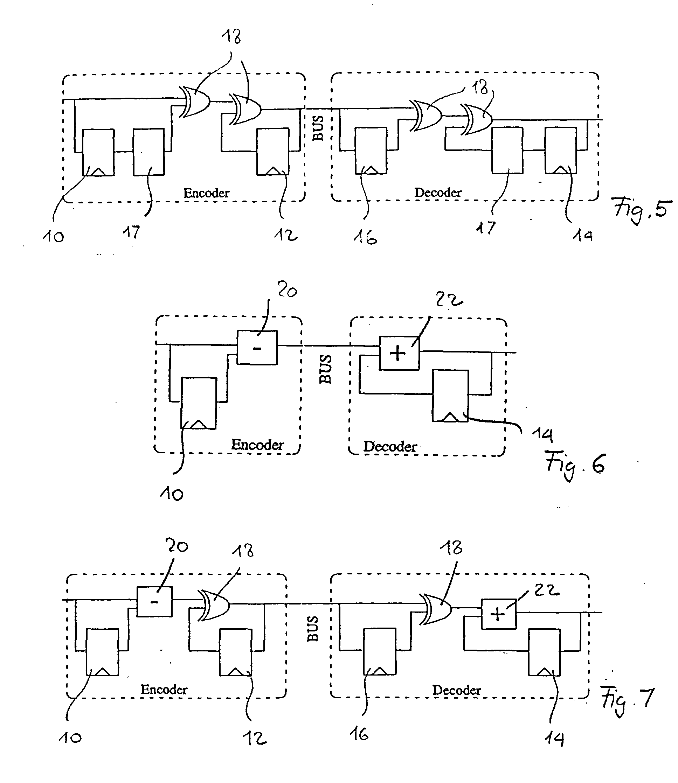

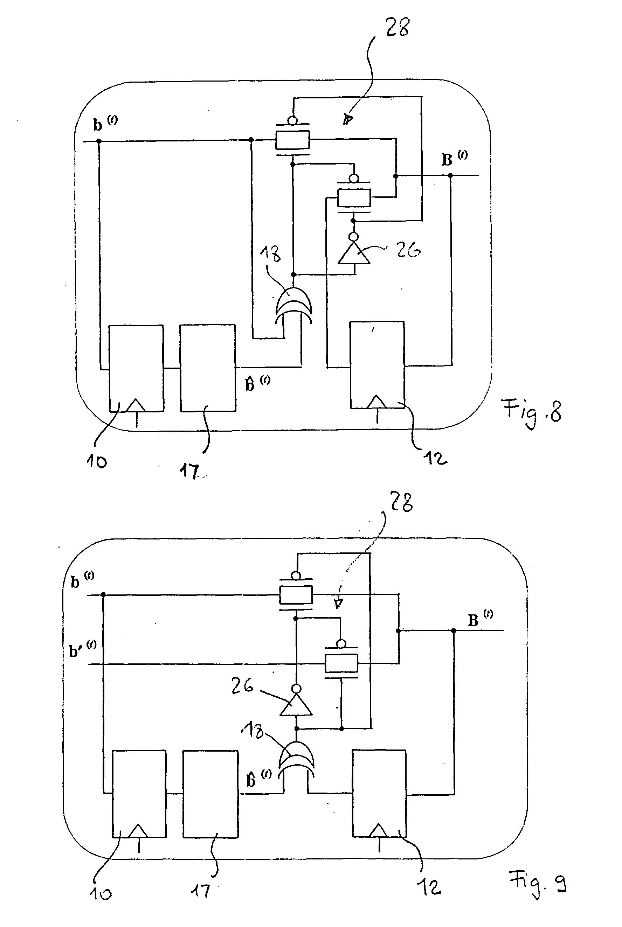

In Figure 3 only, the reference 24 indicates two modules which implement the mux function. Figure 8 shows the details of the encoding section shown in Figure 4 particularly in relation to the fact that the critical path delay extends from the line $b^{(t)}$ towards $B^{(t)}$, passing through the Xor gate 18, the inverter 26 and the pass-gate 28. Figure 9 shows a high-speed version of the encoding section of the architecture for the T0-Xor code shown in Figure 5. In the scheme in Figure 9, the critical path has been reduced to a single pass-gate 28, unlike the delay of the two Xor gates 18 of Figure 5. In the high-speed version of Figure 9, most of the logic has been pre-calculated during the preceding clock cycle. Naturally, provided that the principle of the invention is retained, the details of construction and the types of embodiment can be varied from what has been described and illustrated, without departure from the scope of the present invention, as defined by the attached claims. This is applicable, for example, to the embodiment shown in Figure 6 where the selection block (S in the diagram in Figure 3) is actually absent or, alternatively, can be seen as actually integrated in the decorrelation block, the prediction block being configured to implement the identity function.

## Claims

1. Encoder/decoder architecture for buses, capable of receiving a current value of input information ($b^{(t)}$) relating to a given instant and of generating, from this current input value, a corresponding output value ($B^{(t)}$) relating to the same given instant on encoded bus lines, **characterized in that** it comprises:

   - at least one memory element (10, 12) for storing the respective preceding input information value ($b^{(t-1)}$) and output information value ($B^{(t-1)}$),
   - a prediction block (P) for generating an estimate ($b^{\wedge(t)}$) of the said current input information value on the basis of the said preceding input information value, and
   - a decorrelation block (D) for decorrelating the said current input information value with respect to the said estimate, to produce a decorrelation result ($e^{(t)}$),
        the said current output value ($B^{(t)}$) being adapted to be selected as one of the following:

   - the said current input information value ($b^{(t)}$),
   - the said preceding output value ($B^{(t-1)}$), and
   - the said decorrelation result ($e^{(t)}$).

2. Architecture according to Claim 1, **characterized in that** it comprises a selection block (S) for selecting the said current output value ($B^{(t)}$).

3. Architecture according to Claim 1 or Claim 2, **characterized in that** it comprises corresponding registers (10, 12) for storing the said corresponding preceding input information values ($b^{(t-1)}$) and output information values ($B^{(t-1)}$).

4. Architecture according to any one of the preceding claims, **characterized in that** at least one of the said blocks (P, D, S) is at least partially implemented by means of pass-gates (28).

5. Architecture according to any one of the preceding claims, **characterized in that** it comprises:

   - a redundant line (17), preferably configured to transfer information on the sequentiality of the said information, acting as a prediction block (P),

- an xor logic gate (18), acting as a decorrelation block (D), and
- a multiplexer (24), acting as a selection block (S) for selecting the said current output value.

**6.** Architecture according to Claim 5, **characterized in that** the said selection block (S) comprises an inverter (26) and a. pass-gate (28).

**7.** Architecture according to any one of Claims 1 to 4, **characterized in that** it comprises:

- an identity module, acting as a prediction module (P),
- a decorrelation block (D), acting as an xor logic gate, and
- an inverter, acting as a selection block (S) for selecting the said current output value.

**8.** Architecture according to any one of Claims 1 to 4, **characterized in that** it comprises:

- one out of a redundant line, preferably configured for transferring information on the sequentiality of the said information, and an identity module, acting as a prediction module (P),
- an xor logic gate, acting as a decorrelation block (D), and
- one out of a multiplexer and an inverter, acting as a selection block (S) for selecting the said current output value.

**9.** Architecture according to any one of Claims 1 to 4, **characterized in that** it comprises:

- a redundant line (17), preferably configured for transferring information on the sequentiality of the said information, acting as a prediction module (P),
- an xor logic gate (18), acting as a decorrelation block (D), and
- an xor logic gate (18), acting as a selection block (S) for selecting the said current output value.

**10.** Architecture according to Claim 9, **characterized in that** the said selection block (S) comprises an inverter (26) and a pass-gate (28).

**11.** Architecture according to Claim 1, **characterized in that** it comprises:

- an identity module, acting as a prediction module (P), and
- a difference module (20), acting as a decorrelation block (D), which is also capable of selecting the said current output value ($B^{(t)}$).

**12.** Architecture according to any one of Claims 1 to 4, **characterized in that** it comprises:

- an identity module, acting as a prediction module (P), and
- a difference module (20), acting as a decorrelation block (D), and
- an xor logic gate (18), acting as a selection block (S) capable of selecting the said current output value (B).

**13.** Architecture according to any one of Claims 1 to 4, **characterized in that** it comprises:

- one out of a redundant line (17), preferably configured for transferring information on the sequentiality of the said information, and an identity module, acting as a prediction module (P),
- one out of an xor logic gate (18) and a difference module, acting as a decorrelation block (D), and
- a multiplexer (24), acting as a selection block (S) for selecting the said current output value.

**14.** Architecture according to any one of Claims 1 to 4, **characterized in that** it comprises:

- one out of a redundant line (17), preferably configured for transferring information on, the sequentiality of the said information, and an identity module, acting as a prediction module (P),
- one out of an xor logic gate (18) and a difference module, acting as a decorrelation block (D), and
- an xor logic gate, acting as a selection block (S) for selecting the said current output value.

**15.** Processing system of the bus type, comprising at least one bus interface based on any one of the preceding claims.

16. System according to Claim 15, **characterized in that** the said at least one bus interface operates at sub-system level.

17. System according to Claim 16, **characterized in that** the said at least one bus interface operates at the processor-to-cache bus level.

18. System according to Claim 15, **characterized in that** the said at least one bus interface operates at system level.

19. System according to any one of Claims 15 to 18, in the form of a shared memory multiprocessor system.

20. System according to any one of Claims 15 to 19, implemented by using a structure of the monolithic type (System-On-a-Chip).

21. System according to any one of Claims 15 to 19, implemented by using a structure of the multichip type.

PO

Pn

MM

N0

Nn

I-cache
D-cache

....

I-cache
D-cache

MC

IN

I/O
Controller

....

I/O
Units

CP0

CPm

*Fig. 1*

B1

LS

B2

B2

FMD

B1

B1

B2

B1

B2

(a)

LS

(b)

FMD

B1

E

B2

B2

B1

B2

B1

D

B1

(c)

(d)

*Fig. 2*

S

$\mathbf{b}^{(t)}$

$\mathbf{B}^{(t)}$

$\mathbf{\hat{b}}^{(t)}$

$\mathbf{e}^{(t)}$

12

Fig. 3

10

P

D

24

24

BUS

18

Encoder

17

Decoder

10

17

12

14

Fig. 4

Fig. 5

Fig. 6

Fig. 7

Fig. 8

Fig. 9

**European Patent Office**

## EUROPEAN SEARCH REPORT

Application Number

EP 00 83 0322

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X,D | RAMPRASAD ET AL.: "A coding framework for low-power address and data busses" IEEE TRANSACTIONS ON VERY LARGE SCALE INTEGRATION (VLSI) SYSTEMS, vol. 7, no. 2, June 1999 (1999-06), pages 212-221, XP000833592 New York, US ISSN: 1063-8210 * figures 4-6,12,14 * | 1-21 | H04L25/49 H04L25/14 G06F1/32 H03M5/14 |
| X,D | STAN, BURLESON: "Low-power encodings for global communication in CMOS VLSI" 1996 INTERNATIONAL SYMPOSIUM ON LOW POWER ELECTRONICS AND DESIGN , vol. 5, no. 4, 12 - 14 August 1996, pages 444-455, XP002165901 New York, US ISSN: 1063-8210 * figure 9 * | 1-21 | |
| | | | TECHNICAL FIELDS SEARCHED (Int.Cl.7) H04L G06F H03M |

The present search report has been drawn up for all claims

| Place of search | Date of completion of the search | Examiner |
|---|---|---|
| THE HAGUE | 12 June 2001 | Scriven, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)